# EUROPÄISCHE PATENTANMELDUNG

(11) **EP 2 011 665 A2**
(43) Veröffentlichungstag der Anmeldung: **07.01.2009**
(21) Anmeldenummer: 08009319.8
(22) Anmeldetag: 21.05.2008
(51) Int. Cl.: B42D 15/00

(54) **Druckprodukt mit elektrisch funktionaler Schicht**

(30) Priorität: 04.07.2007 DE 102007031062
(71) Anmelder: manroland AG, 63075 Offenbach/Main (DE)
(72) Erfinder: Walther, Thomas, Dipl.-Ing., 63067 Offenbach (DE)
(74) Vertreter: Stahl, Dietmar

(57) **Zusammenfassung**

Die Erfindung betrifft eine drucktechnisch hergestelltes Druckprodukt wie eine Verpackung, Eingabetastatur, Spiel, Werbemittel oder Display bestehend aus einer transparenten Kunststofffolie (1), einer Bildebene (2), die aus einer gedruckten Bildinformation besteht, einer opaken oder teilopaken deckenden Ebene (3), die durch die Laminierung oder Kaschierung, unter Zuhilfenahme eines Haftvermittlers, einer opaken Kunststofffolie oder Papiers erzielt wird

Das Produkt soll verbessert und kostengünstiger herstellbar sein.

Dazu wird auf die deckende, opake Ebene (3) eine elektrisch funktionale Ebene (4) vor oder nach dem Kaschier- oder Laminiervorgang mittels drucktechnischer Verfahren aufgedruckt.

## Beschreibung

Die Erfindung betrifft ein Druckprodukt mit elektrisch funktionaler Schicht nach dem Oberbegriff von Anspruch 1 und ein dazu gehöriges Herstellungsverfahren nach dem Oberbegriff von Anspruch 12 oder 13.

Es ist bekannt mit gefüllten Druckfarben (z.B. mit Silber gefüllte Druckfarben) oder mit leitfähigen Polymeren elektrische Funktionalitäten zu drucken. Zum Einsatz kommen alle bekannten Druckverfahren, wie der Tintenstrahldruck, der Tiefdruck, der Siebdruck, der Offsetdruck oder der Hoch- und Flexodruck. Oftmals wird für den Druck der elektrischen Funktionalitäten auch Kombinationsdrucke der vorab erwähnten Druckverfahren eingesetzt.

Gedruckte elektrische Funktionalitäten stellen sich im einfachsten Fall durch gedruckte Leiterbahnen oder Tastenfelder für die Herstellung von Tastaturen und Spielen, Antennen für RFID (radio frequency identification device) dar oder sie können auch komplexere funktionale Elemente, wie Transistoren oder Speicheranwendungen sein.

Der Vorteil der gedruckten Elektronik liegt unter anderem in der möglichen Flexibilität der Druckprodukte. So können Folien mit Leiterbahnen sich zum Beispiel der Kontur eines Produktes anpassen oder auch zusammengerollt Platz sparend transportiert werden.

Vielfach wurde diskutiert die gedruckten funktionalen elektronischen Elemente zu überdrucken, um diese in dem Druckbild aufgehen zulassen. Die Eigenfarbe der gedruckten elektrischen Elemente, aber auch die oftmals, auch bei transparenten elektrisch leitfähigen Strukturen oder Elementen, mit der Zeit auftretenden Verfärbungen stören den visuellen und optischen Eindruck des Drucks. Druckfarben sind meist nicht deckend, sondern lasierend, also leicht durchscheinend, so dass sie den Untergrund durchscheinen lassen. Im Rasterdruck kommt noch zusätzlich erschwerend hinzu, dass die Zwischenräume zwischen den Rasterpunkten den Hintergrund deutlich erkennen lassen. Deswegen ist der direkte Druck eines farbigen Bildes auf eine leitfähige Struktur nur selten möglich.

Transparente Kunststofffolien werden klassisch zuerst mit einem Druckbild versehen auf das als letzte Schicht eine anschließende opake oder teilopake Deckweißschicht Inline während des Druckvorgangs oder Offline in einer separaten Beschichtungseinrichtung aufgetragen werden. Der Vorteil liegt darin, dass die Druckschicht sich in der Verpackung befindet und durch die transparente Folie betrachtet werden kann. Die Kunststofffolie schützt das Druckbild gegen Verkratzen oder Beschädigung während des Transports und der Lagerung.

Es ist weiterhin bekannt, verschiedene Folienschichten zu einer Verbundfolie zusammen zu laminieren bzw. unter Zuhilfenahme eines Haftvermittlers zusammen zu kaschieren

Aufgabe der Erfindung ist es daher, ein farblich und optisch ansprechendes Druckprodukt zu gestalten und dieses mit einer elektrischen Funktionalität zu versehen.

Gelöst wird die Aufgabe durch die Merkmale eines Druckproduktes nach Patentanspruch 1 oder die Merkmale von Herstellungsverfahren nach Ansprüchen 12 oder 13.

Sinnvolle Weiterbildungen ergeben sich aus den jeweiligen Unteransprüchen.

Erfindungsgemäß wird das Druckprodukt dadurch erstellt, indem
- zuerst ein Druckbild auf eine transparente Kunststofffolie aufgedruckt wird
- und anschließend diese transparente Folie mit einer opaken Folie oder Papier laminiert
- oder unter Zuhilfenahme eines Haftvermittlers kaschiert wird,
- wobei die opake Folie oder das Papier auf der transparenten Folie befindlichem Druckbild abgewandten Seite eine zumindest teilweise drucktechnisch erzeugte Funktionalität aufgetragen ist.
Durch diesen Ansatz wird gewährleistet, dass das Druckbild brillant und ohne Störungen ist und gleichzeitig die elektrische Funktionalität in hervorragender Weise gewährleistet ist.

Im Folgenden wird mit Hilfe von zeichnerischen Darstellungen ein Ausführungsbeispiel der Erfindung näher beschrieben.

Hierbei zeigen
- Figur 1: eine erste Stufe der Herstellung des Druckproduktes und
- Figur 2: eine zweite Stufe der Herstellung des Druckproduktes.

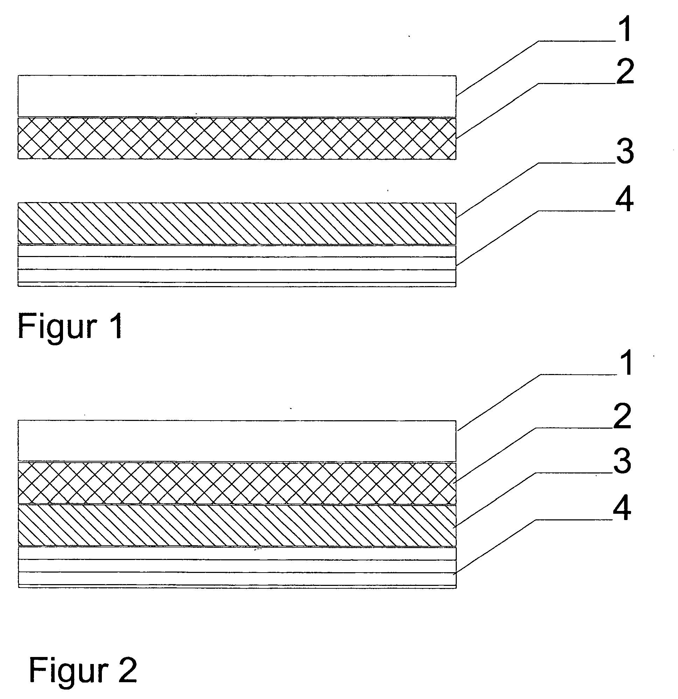

In Figur 1 ist eine transparente Kunststofffolie 1 mit einer Bildinformation 2 gezeigt. Auf die transparente Kunststofffolie 1 wird im Bogen- oder Rollenrotationsdruck zuerst die Bildinformation 2 aufgedruckt, wobei mindestens ein Teil des Bildes im Offset-, Tief- oder Flexodruck aufgedruckt wird.

Anschließend wird diese transparente Kunststofffolie 1 gemäß Figur 2 mit der darauf befindlichen gedruckten Bildinformation 2 mit einer opaken, vorzugsweise weißen Kunststofffolie 3 oder einem Papier 3, unter Zuhilfenahme eines Haftvermittlers durch Kaschieren verbunden oder unter Wärmeeinfluss laminiert. Die opake Folie 3 trägt schon bei dem Kaschier- oder Laminiervorgang eine zumindest teilweise drucktechnisch erzeugte elektrisch funktionale Ebene 4. Andererseits kann die elektrisch funktionale Ebene 4 auch nach dem Kaschier- bzw. Laminiervorgang auf die kaschierte bzw. laminierte Folie oder das Papier 3 zumindest teilweise aufgedruckt werden.

Die Laminierung oder Kaschierung der opaken, deckenden Schicht 3 kann auch während des Durchlaufens eines Druckprozesses in einer Druckmaschine erzeugt werden, wobei auf die deckende, oben liegende Schicht 3 in besonders bevorzugter Weise in demselben Druckprozess bzw. Druckdurchgang wie die elektrische funktionale Schicht 4 aufgedruckt wird.

Der Aufdruck der elektrisch funktionalen Schicht bzw. Schichten 4 erfolgt in einem der Druckverfahren Offsetdruck, Flexodruck oder Tiefdruck oder in einer Kombination der genannten Druckverfahren. Die funktionale elektrische Schicht 4 kann dabei komplett drucktechnisch hergestellt, oder als so genannte Hybridanwendung aufgebracht werden.

Die gedruckte elektrische Funktionalität ist zum Beispiel eine Leiterbahn, in Kombination mit diskreten elektrischen Bauelementen, wie zum Beispiel Chips (elektronische Schaltungen) oder Leuchtdioden (LED's) aufweisen.

Der Druck der Bildinformation 2 auf die transparente Folie erfolgt in einem Druckgang, vorzugsweise im Offsetdruckverfahren. Anschließend kann offline, zum Beispiel in einer separaten Kaschier- oder Laminiervorrichtung die opake Folie oder das Papier 3 aufkaschiert oder laminiert werden.
Die opake Folie 3 kann vor dem Kaschier- oder Laminiervorgang zumindest teilweise mit der elektrischen Funktionalität 4 bedruckt worden sein. Alternativ dazu kann der Verbund aus transparenter Folie 1, Druckbildschicht 2 und der opaken Folie oder des Papiers 3 auch nach dem Kaschier- oder Laminiervorgang als Verbund mit der elektrischen Funktionalität 4 zumindest teilweise in einem Druckverfahren bedruckt werden.

Die opake Folie oder das Papier 3 kann Aussparungen aufweisen, die eine Durchkontaktierung erlauben oder das Durchscheinen einer elektrischen Anzeige oder einer anderen Anzeigevorrichtung, wie zum Beispiel einer Leuchtdiode (LED), erlauben.

Die elektrische funktionale Ebene 4 kann gegebenenfalls durch die Kaschierung oder die Laminierung einer weiteren Folie oder durch den Auftrag einer Schicht eines Schutzlackes vor Beschädigungen geschützt werden.

Durch die erfindungsgemäß gefundene Lösung wird ein brillantes Druckbild ermöglicht, dass dann nicht von gegebenenfalls optisch störend wirkenden Elementen der elektrischen Funktionsschicht 4 negativ beeinflusst wird.

Mit dem vorgeschlagenen Verfahren können vorteilhaft spezielle Druckprodukte erzeugt werden. Das vorgeschlagene Druckprodukt ist in seiner spezifischen Kombination von gedruckter Bildinformation und elektrisch funktionaler Information geeignet, wirkungsvolle Kunststoffverpackungen, Eingabetastaturen, oder auch Spiele herzustellen.

### Bezugszeichenliste

- 1: Transparente Kunststofffolie
- 2: Gedruckte Bildebene / gedrucktes Druckbild
- 3: Opake Kunststofffolie oder Papier
- 4: Elektrisch funktionale Schicht

## Patentansprüche

1. Drucktechnisch hergestellte Verpackung, Eingabetastatur, Spiel, Werbemittel oder Display bestehend aus einer transparenten Kunststofffolie (1), einer Bildebene (2), die aus einer gedruckten Bildinformation besteht, einer opaken oder teilopaken deckenden Ebene (3), die durch die Laminierung oder Kaschierung, unter Zuhilfenahme eines Haftvermittlers, einer opaken Kunststofffolie oder Papiers erzielt wird,
**gekennzeichnet dadurch,**
**dass** auf die deckende, opake Ebene (3) eine elektrisch funktionale Ebene (4) vor oder nach dem Kaschier- oder Laminiervorgang aufgedruckt wird, die zu mindestens teilweise drucktechnisch erzeugt wird.

2. Druckprodukt nach Anspruch 1,
**gekennzeichnet dadurch,**
**dass** eine Bildebene (2) vorgesehen ist, die in einem Druckverfahren des Offsetdrucks, des Tiefdrucks oder des Flexodrucks oder in einer Kombination der genannten Druckverfahren auf die transparente Folie (1) aufgedruckt wird.

3. Druckprodukt nach Anspruch 1,
**gekennzeichnet dadurch,**
**dass** eine elektrisch funktionale Ebene (4) vorgesehen ist, die zumindest teilweise in einem der Druckverfahren Offsetdruck, Tiefdruck oder Flexodruck oder in Kombination der genannten Druckverfahren auf die opake Folie oder das Papier (3) aufgetragen wird.

4. Druckprodukt nach Anspruch 3,
**gekennzeichnet dadurch,**
**dass** eine Ebene (4) der elektrischen Funktionalität vorgesehen ist, in der die gesamte elektrische Funktionalität des Druckproduktes drucktechnisch erzeugt wird.

5. Druckprodukt nach Anspruch 3,
**gekennzeichnet dadurch, dass** eine Ebene (4) der elektrischen Funktionalität vorgesehen ist, in der die elektrische Funktionalität teilweise drucktechnisch erzeugt wird und teilweise durch diskrete elektrische Bauelemente, wie integrierte Schaltkreis (IC's) oder Leuchtdioden (LED's) erzeugt wird.

6. Druckprodukt nach Anspruch 1, 3, 4 oder 5,
**gekennzeichnet dadurch, dass** eine Ebene (4) der elektrischen Funktionalität vorgesehen ist, in der die drucktechnisch erzielten elektrischen Funktionalitäten mittels leitfähiger mit metallischen Pigmenten gefüllter Druckfarben und/oder durch den Druck von leitfähigen Polymeren hergestellt sind.

7. Druckprodukt nach Anspruch 1 bis 6, **gekennzeichnet dadurch, dass** eine Ebene (4) der elektrischen Funktionalität vorgesehen ist, in der die ein RFID-Transponder oder ein 1-bit Transponder für den Diebstahlschutz ist.

8. Druckprodukt nach Anspruch 1 bis 6, **gekennzeichnet dadurch, dass** die elektrisch funktionale Ebene (4) Leiterbahnen und/oder Tastaturelemente aufweist.

9. Druckprodukt nach Anspruch 1 bis 6, **gekennzeichnet dadurch,**
**dass** die elektrisch funktionale Ebene (4) eine Stromversorgung, wie eine Batterie aufweist.

10. Druckprodukt nach Anspruch 1 bis 6, **gekennzeichnet dadurch,**
**dass** die elektrisch funktionale Ebene (4) eine Anzeigevorrichtung, wie eine LED-Anzeige, aufweist.

11. Druckprodukt nach Anspruch 1 bis 6, **gekennzeichnet dadurch,**
**dass** die elektrisch funktionale Ebene (4) einen oder mehrere Sensoren zur Erfassung der Temperatur oder des Reifezustands eines verpackten Lebensmittels aufweist.

12. Einstufiges Herstellungsverfahren eines Druckproduktes, wie einer drucktechnisch hergestellten Verpackung, Eingabetastatur, Spiel, Werbemittel oder Display, bestehend aus einer transparenten Kunststofffolie (1), einer Bildebene (2), die aus einer gedruckten Bildinformation besteht, einer opaken oder teilopaken deckenden Ebene (3), die durch die Laminierung oder Kaschierung, unter Zuhilfenahme eines Haftvermittlers, einer opaken Kunststofffolie oder Papiers erzielt wird, nach Anspruch 1, 2 oder 3,
**gekennzeichnet dadurch,**
**dass** auf die transparente Kunststofffolie (1) ein Druckbild aufgedruckt wird und anschließend "inline" während des Durchlaufs durch die Druckmaschine eine opake Folie oder Papier (3) kaschiert oder laminiert wird, auf die dann zu mindestens teilweise mit einer elektrisch Funktionalität in einem Druckverfahren "inline" während des Drucklaufs durch die Druckmaschine aufgedruckt wird.

13. Mehrstufiges Herstellungsverfahren eines Druckproduktes, wie einer drucktechnisch hergestellten Verpackung, Eingabetastatur, Spiel, Werbemittel oder Display, bestehend aus einer transparenten Kunststofffolie (1), einer Bildebene (2), die aus einer gedruckten Bildinformation besteht, einer opaken oder teilopaken deckenden Ebene (3), die durch die Laminierung oder Kaschierung, unter Zuhilfenahme eines Haftvermittlers, einer opaken Kunststofffolie oder Papiers erzielt wird, nach Anspruch 1,2 oder 3,
**gekennzeichnet dadurch,**
**dass** in einem ersten Arbeitsschritt auf die transparente Kunststofffolie (1) ein Druckbild aufgedruckt wird und anschließend die bedruckte transparente Folie (1) mit dem Druckbild (2) in einer separaten Kaschier- oder Laminiervorrichtung eine opake Folie oder Papier (3) kaschiert bzw. laminiert wird, und der Verbund aus transparenter Kunststofffolie (1), Druckbildebene (2) und opaker Folie oder Papier (3) dann in einem weiteren Druckvorgang zumindest teilweise mit einer elektrischen Funktionalität bedruckt wird.

14. Mehrstufiges Herstellungsverfahren eines Druckproduktes, wie einer drucktechnisch hergestellten Verpackung, Eingabetastatur, Spiel, Werbemittel oder Display, bestehend aus einer transparenten Kunststofffolie (1), einer Bildebene (2), die aus einer gedruckten Bildinformation besteht, einer opaken oder teilopaken deckenden Ebene (3), die durch die Laminierung oder Kaschierung, unter Zuhilfenahme eines Haftvermittlers, einer opaken Kunststofffolie oder Papiers erzielt wird, nach Anspruch 1,2 oder 3,
**gekennzeichnet dadurch,**
**dass** in einem ersten Arbeitsschritt auf die transparente Kunststofffolie (1) ein Druckbild aufgedruckt wird und anschließend die bedruckte transparente Folie (1) mit dem Druckbild (2) in einer separaten Kaschier- oder Laminiervorrichtung eine opake Folie oder Papier (3) kaschiert bzw. laminiert wird, die zuvor zumindest teilweise mit einer elektrischen Funktionalität bedruckt wurde.

15. Verfahren nach einem der Ansprüche 12, 13 oder 14,
**gekennzeichnet dadurch,**
**dass** der Druck der Bildinformationsebene (2) in einer Bogenrotationsdruckmaschine in Verbindung mit oder ohne Lackwerken oder in einer Rollenrotationsdruckmaschine erfolgt.
